# EUROPÄISCHE PATENTSCHRIFT

(11) **EP 4 064 563 B1**
(45) Veröffentlichungstag und Bekanntmachung des Hinweises auf die Patenterteilung: **18.06.2025**
(21) Anmeldenummer: 21164491.9
(22) Anmeldetag: 24.03.2021
(51) Int. Cl.: H03K 17/0814, H03K 17/16

(54) **ELEKTRONISCHER SCHALTER**
ELECTRONIC SWITCH
COMMUTATEUR ÉLECTRONIQUE

(43) Veröffentlichungstag der Anmeldung: 28.09.2022
(73) Patentinhaber: Siemens Aktiengesellschaft, 80333 München (DE)
(72) Erfinder: Handt, Karsten, 92348 Berg (DE)
(74) Vertreter: Siemens Patent Attorneys

(56) Entgegenhaltungen:
- WO-A1-2020/099103
- CN-A- 108 736 874
- CN-A- 110 445 359
- CN-A- 110 492 439
- CN-A- 112 311 215

## Beschreibung

Die Erfindung betrifft einen elektronischen Schalter mit einem ersten und einem zweiten Anschluss, zwischen denen eine elektrisch leitende Verbindung herstellbar oder unterbrechbar ist und mit wenigstens einem zwischen den ersten und zweiten Anschluss geschalteten bidirektionalen abschaltbaren Halbleiter-Schaltelement.

An der Stelle von klassischen Leitungsschutzschaltern könnten zukünftig sowohl in AC- als auch in DC-Netzen halbleiterbasierte Leitungsschutzschalter, in der Folge als elektronische Schalter bezeichnet, zum Einsatz kommen, also solche, die den Strompfad mit Halbleiterschaltern wie IGBTs unterbrechen. Der elektronische Schalter weist dazu wenigstens einen, üblicherweise aber zwei anti-seriell oder anti-parallel geschaltete Halbleiterschalter im Strompfad auf.

Solche elektronischen Schalter haben Vorteile bezüglich der Geschwindigkeit, mit der Fehlerströme abgeschaltet werden können. Das ist beispielsweise vorteilhaft in DC-Netzen, die in zukünftigen Industrieanlagen Verluste reduzieren, den direkten Energieaustausch zwischen Umrichtern, Speichern und Motoren gewährleisten und eine erhöhte Robustheit erzielen sollen. Die geringen Kabellängen führen dort zu sehr kleinen Längsinduktivitäten in den Zuleitungen, die wiederum bewirken, dass Fehlerströme einen sehr steilen Stromanstieg aufweisen. Die nötige schnelle Abschaltung wird von Halbleiterschaltern besser als von mechanischen Schaltern ermöglicht, da Halbleiterschalter den Fehler nach der Erkennung in wenigen 100ns abschalten können.

Als problematisch stellt sich dabei der nach einer Abschaltung von den Induktivitäten der Leitungen und/oder der Lasten weitergetriebene Strom. Dieser führt mangels eines Freilaufpfads zu einer hohen Spannung über den elektronischen Schalter. Steigt diese über die Spannungsfestigkeit des oder der Halbleiterschalter an, können diese beschädigt werden.

Um dem Problem zu begegnen, sind verschiedene Lösungen bekannt. Beispielsweise kann parallel zu den Halbleiterschaltern ein Kondensator vorhanden sein, der den Spannungsanstieg nach einer Abschaltung soweit verlangsamt, dass der Abbau der induktiv gespeicherten Energie unproblematisch ist. Auch kann der elektronische Schalter einen Varistor aufweisen, der entweder seriell zu dem Kondensator oder aber zwischen den Polen des Stromnetzes angeordnet ist. Solche Lösungen sind beispielsweise aus der WO 2019/011642 A1 und der WO 2020/099103 A1 bekannt. Nachteilig an den bekannten Lösungen ist, dass die verwendeten Kondensatoren große und schwere Bauelemente sind, die nicht unerheblich zur gesamten Baugröße des elektronischen Schalters beitragen.

Es ist Aufgabe der vorliegenden Erfindung, einen verbesserten elektronischen Schalter anzugeben, der insbesondere eine gegenüber bekannten Lösungen verringerte Baugröße aufweist.

Diese Aufgabe wird gelöst durch einen elektronischen Schalter mit den Merkmalen von Anspruch 1.

Der erfindungsgemäße elektronische Schalter weist einen ersten und einen zweiten Anschluss auf, zwischen denen eine elektrisch leitende Verbindung herstellbar oder unterbrechbar ist. Typischerweise wird der elektronische Schalter mit diesen Anschlüssen seriell in einen Pol eines elektrischen Netzwerks eingebunden und kann somit die elektrische Verbindung in diesem Pol unterbrechen der herstellen.

Der elektronische Schalter umfasst weiterhin ein bidirektionales abschaltbares Halbleiter-Schaltelement, das zwischen dem ersten und zweiten Anschluss angeordnet ist, also den ersten und zweiten Anschluss verbindet. Mittels dieses bidirektionalen Halbleiter-Schaltelements ist die Verbindung zwischen dem ersten und zweiten Anschluss herstellbar oder unterbrechbar. Da das Halbleiter-Schaltelement bidirektional ist, spielt dabei die Richtung der Stromflusses keine Rolle, das Halbleiter-Schaltelement kann Strom beider Stromrichtungen unterbrechen und Spannung in beiden Richtungen aufbauen.

Schließlich umfasst der elektronische Schalter eine Spannungsbegrenzungs-Schaltung, die parallel zu dem Halbleiter-Schaltelement geschaltet ist. Die Spannungsbegrenzungs-Schaltung umfasst mehrere bidirektionale Suppressor-Dioden. Im Falle mehrerer Suppressor-Dioden sind diese in einer Serienschaltung angeordnet. Es versteht sich dass die bidirektionalen Suppressor-Dioden als integrierte Bauelemente oder als einzelne unidirektionale Bauelemente, die anti-seriell geschaltet sind, vorliegen können.

Für die Erfindung wurde erkannt, dass Suppressor-Dioden vorteilhaft eine Begrenzung einer sich aufbauenden Spannung über den Halbleiterschalter ermöglichen. Da diese Begrenzung über einen nicht destruktiven Durchbruch der Suppressor-Dioden passiert und einen entsprechenden Stromfluss bewirkt, entsteht bei einer solchen Begrenzung der Spannung eine Verlustleistung in der Suppressor-Diode. Es hat sich herausgestellt, dass Suppressor-Dioden erhältlich sind, bei denen über einen Abschaltzeitraum von ca. 200 µs eine Peak-Leistung von mehreren 10 kW möglich ist, was den Einsatz in modernen DC-Netzen auch bei Betriebsspannungen von beispielsweise 800 V und bei induktiv gespeicherten Energien, die im Größenordnungsbereich von 1 bis 50 J liegen, möglich macht.

Durch den Einsatz der Suppressor-Diode oder Suppressor-Dioden entfällt der ansonsten häufig zu Spannungsbegrenzung verwendete Kondensator. Da die Suppressor-Dioden deutlich kleiner und leichter sind als ein für dasselbe Netzwerk dimensionierter Kondensator, ergibt sich eine deutliche Ersparnis in Gewicht und Platz auch bei Verwendung mehrerer Suppressor-Dioden. Auch die in bekannten Lösungen verwendeten Varistoren können entfallen. Dabei erweist sich auch als vorteilhaft, dass die Suppressor-Dioden eine außerordentlich hohe Reaktionsgeschwindigkeit haben und somit auch bei geringen Leitungsinduktivitäten und dementsprechend schnellem Stromanstieg eine Spannungsbegrenzung erreichen.

Vorteilhafte Ausgestaltungen der erfindungsgemäßen Einrichtung gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können für den elektronischen Schalter noch zusätzlich folgende Merkmale vorgesehen werden:
Der elektronische Schalter umfasst erfindungsgemäß einen Kondensator, der parallel zu einer oder mehreren der Suppressor-Dioden angeordnet ist. In Messungen wurde erkannt, dass trotz der theoretisch außerordentlich schnellen Reaktion der Suppressor-Dioden auf eine Überspannung in einer realen Schaltung die Spannung initial deutlich die summierte Durchbruchsspannung der Suppressor-Dioden übersteigt und erst nach Verstreichen einer Zeitspanne im Bereich von 1 µs in den Bereich der summierten Durchbruchsspannung abfällt. In der Folge wird der Begriff summierte Durchbruchsspannung gebraucht, auch wenn nur eine Suppressor-Diode vorhanden ist, wobei in diesem Fall die summierte Durchbruchsspannung eben die Durchbruchsspannung der einen Suppressor-Diode ist. Je nach Konfiguration des elektronischen Schalters, d.h. je nach dem Verhältnis von Betriebsspannung eines angeschlossenen Netzes, Spannungsfestigkeit des Halbleiter-Schaltelements und summierter Durchbruchsspannung der Suppressor-Dioden kann diese initiale Überspannung unproblematisch sein oder aber weitere Maßnahmen sinnvoll machen.

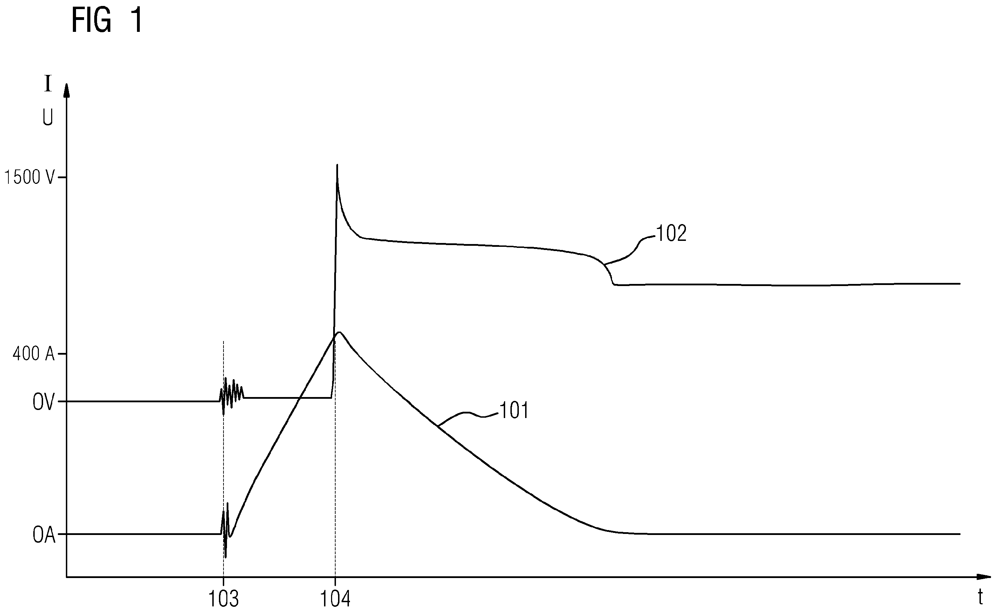

Figur 1 zeigt dazu einen gemessenen Verlauf des Stroms 101 über einen beispielhaften elektronischen Schalter sowie den Verlauf der Spannung 102 über den elektronischen Schalter.

Hierbei weist der elektronische Schalter drei in Reihe geschaltete Suppressor-Dioden auf, aber nicht den Kondensator. Der elektronische Schalter wird zum Zeitpunkt 103 eingeschaltet, wobei lastseitig vom Schalter direkt ein Kurzschluss vorliegt. Der Strom steigt daraufhin an und wird vom Schalter direkt nach der Detektion des Fehlers abgeschaltet, wobei sich aufgrund der verwendeten Induktivität ein Peakstrom von 470 A ergibt. Zu diesem Zeitpunkt 104 zeigt die Spannung 102 eine deutliche Spitze mit einer Höhe von etwas über 1600 V.

Da auch dieser initiale Spannungspuls bereits problematisch für das Halbleiter-Schaltelement sein kann, wird vorteilhaft der Kondensator parallel zu wenigstens einer der Suppressor-Dioden angeordnet. Dadurch wird erreicht, dass die initial auftretende Spannungsspitze abgemildert wird, da die betroffene oder betroffenen Suppressor-Dioden anfänglich - bis zur Aufladung des Kondensators - überbrückt wird, wodurch zu Anfang nur eine verringerte summierte Durchbruchsspannung vorliegt und auch die initiale Spannungsspitze, die über die Durchbruchsspannungen hinausgeht, entsprechend verringert anfällt.

Nach der Aufladung des Kondensators ist die Überbrückung nicht mehr vorhanden und die parallel zum Kondensator liegenden Suppressor-Diode(n) tragen mit ihrer Durchbruchsspannung zur gesamten Gegenspannung bei, die über dem elektronischen Schalter aufgebaut wird.

Da der so im elektronischen Schalter verwendete Kondensator den Spannungsaufbau über den elektronischen Schalter nicht für den gesamten Abschaltzeitraum dämpfen muss, sondern nur in einer kurzen Anfangszeit von weniger als 10 µs, kann dessen Kapazität deutlich kleiner ausfallen als bei bekannten Lösungen. Daher sind seine Baugröße und Gewicht deutlich geringer.

Der Kondensator kann dabei in bestimmten Ausgestaltungen parallel zu genau einer der Suppressor-Dioden angeordnet sein.

Erfindungsgemäß sind dabei mehrere Suppressor-Dioden vorhanden, so dass der Kondensator parallel zu weniger als allen Suppressor-Dioden angeordnet ist. Es ist vorteilhaft, wenn neben der oder den überbrückten Suppressor-Dioden noch weitere, in Serie angeordnete Suppressor-Dioden vorhanden sind, da dann auch im Moment der Abschaltung bereits eine Gegenspannung gegen den induktiv weitergetriebenen Stromfluss aufgebaut wird und damit sich der Kurzschlussstrom nicht weiter aufbauen kann. Dadurch wird ein weiterer Aufbau induktiv gespeicherter Energie vermieden, die wieder abgebaut werden muss.

Es ist zweckmäßig, wenn die Summe der Durchbruchsspannungen aller Suppressor-Dioden kleiner als die Spannungsfestigkeit des Halbleiter-Schaltelements ist. Dadurch wird die Spannung über das Halbleiter-Schaltelement auf einen Wert begrenzt, der Schaden am Halbleiter-Schaltelement vermeidet. Gleichzeitig ist es vorteilhaft, wenn die Summe der Durchbruchsspannungen aller Suppressor-Dioden größer als 60 %, insbesondere größer als 80 % und in einer besonderen Ausgestaltung größer als 90 % der Spannungsfestigkeit des Halbleiterschalters ist. Durch eine summierte Durchbruchsspannung, die möglichst hoch liegt, wird der induktiv getriebene Strom nach der Abschaltung des elektronischen Schalters schneller abgebaut.

Der Kondensator kann vorteilhaft eine Kapazität von weniger als 10 µF, insbesondere weniger als 5 µF aufweisen. In besonderen Ausgestaltungen kann der Kondensator eine Kapazität von weniger als 2 µF aufweisen. Er ist damit deutlich kleiner als ein typischer Kondensator, der in bekannten Lösungen für die Spannungsbegrenzung verwendet wird und eine Kapazität von beispielsweise 50 µF aufweist.

Das Halbleiter-Schaltelement umfasst erfindungsgemäß zwei anti-seriell oder anti-parallel geschaltete Halbleiterschalter. Solche Schaltungen aus zwei Halbleiterschaltern, beispielsweise aus zwei IGBTs sind erhältlich als integrierte Module, sie können aber auch als einzelne und separate Bauelemente vorliegen. Im Falle anti-seriell geschalteter Schalter umfassen diese bevorzugt die bekannten jeweils in Serie vorliegenden Freilaufdioden. Die Halbleiterschalter weisen bevorzugt eine Spannungsfestigkeit von wenigstens 600 V, insbesondere wenigstens 1200 V auf.

Der elektronische Schalter kann eine Vorladeschaltung aufweisen. Diese umfasst eine Serienschaltung mit einer Schalteinrichtung, beispielsweise einem weiteren bidirektionalen Halbleiter-Schaltelement, und einem Strombegrenzungswiderstand. Die Vorladeschaltung ist dabei parallel zu dem Halbleiter-Schaltelement geschaltet, also ebenfalls zwischen dem ersten und zweiten Anschluss angeordnet. Die Vorladeschaltung kann verwendet werden, um vor einem Einschalten des elektronischen Schalters lastseitig vorhandene Kapazitäten mit einem begrenzten Stromfluss aufzuladen, also die Spannungsdifferenz zwischen den beiden Anschlüssen vor dem eigentlichen Einschalten zu verringern. Dadurch wird der nahezu unbegrenzte Stromfluss vermieden, der ansonsten beim Einschalten des elektronischen Schalters auftreten würde, sofern eine nennenswerte lastseitige Kapazität vorliegt.

Der elektronische Schalter kann vorteilhaft in einem elektrischen Netzwerk, insbesondere einem DC-Netzwerk eingesetzt werden. Dabei kann ein solcher elektronischer Schalter oder auch eine Mehrzahl der elektronischen Schalter im Netzwerk verwendet werden. Dabei ist der elektronische Schalter bevorzugt mit seinem ersten und zweiten Anschluss in einen Pol des Netzwerks geschaltet, so dass der Strompfad des Laststroms durch das Halbleiter-Schaltelement führt. Es ist dabei zweckmäßig, wenn die summierte Durchbruchsspannung der Suppressor-Dioden größer ist als die Betriebsspannung des elektrischen Netzwerks, damit bei der Abschaltung eine ausreichende Gegenspannung erzeugt wird, die zu einem vollständigen Abbau des Stroms führt. Das elektrische Netzwerk hat bevorzugt eine Betriebsspannung wenigstens 400 V, insbesondere wenigstens 800 V.

Der elektronische Schalter kann eine Steuerungseinrichtung umfassen, die das Halbleiter-Schaltelement ansteuert. Die Steuerungseinrichtung kann ausgestaltet sein, den durch das Halbleiter-Schaltelement fließenden Strom zu messen. Der von der Steuerungseinrichtung gemessene Strom entspricht somit den im Netzwerk fließenden Strom, also den Laststrom. Die Steuerungseinrichtung kann weiterhin ausgestaltet sein, eine Abschaltung des Halbleiter-Schaltelements zu bewirken, wenn der Strom einen Schwellwert überschreitet. Der Schwellwert ist dabei kennzeichnend für einen Fehlerstrom gewählt. Der elektronische Schalter wird in diesem Fall also als Leitungsschutzschalter betrieben.

Weitere Vorteile und Merkmale sind der folgenden Beschreibung von Ausführungsbeispielen anhand der Figuren zu entnehmen. In den Figuren bezeichnen gleiche Bezugszeichen gleiche Bauteile und Funktionen.

Es zeigen:
Figur 1 ein Diagramm, das für einen Abschaltvorgang Strom und Spannungsverläufe zeigt,
Figur 2 ein Gleichspannungssystem mit einem ersten elektronischen Schalter, der nicht der Erfindung zugehörig ist,
Figur 3 einen zweiten elektronischen Schalter, der ein Beispiel für die Erfindung ist,

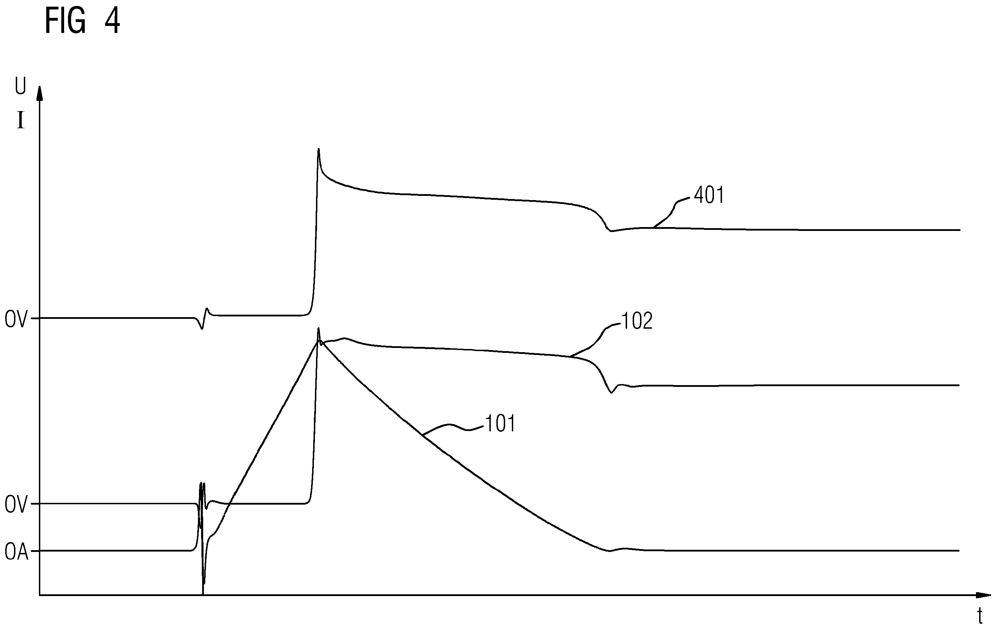

Figur 4 ein weiteres Diagramm, das für einen Abschaltvorgang Strom und Spannungsverläufe zeigt.

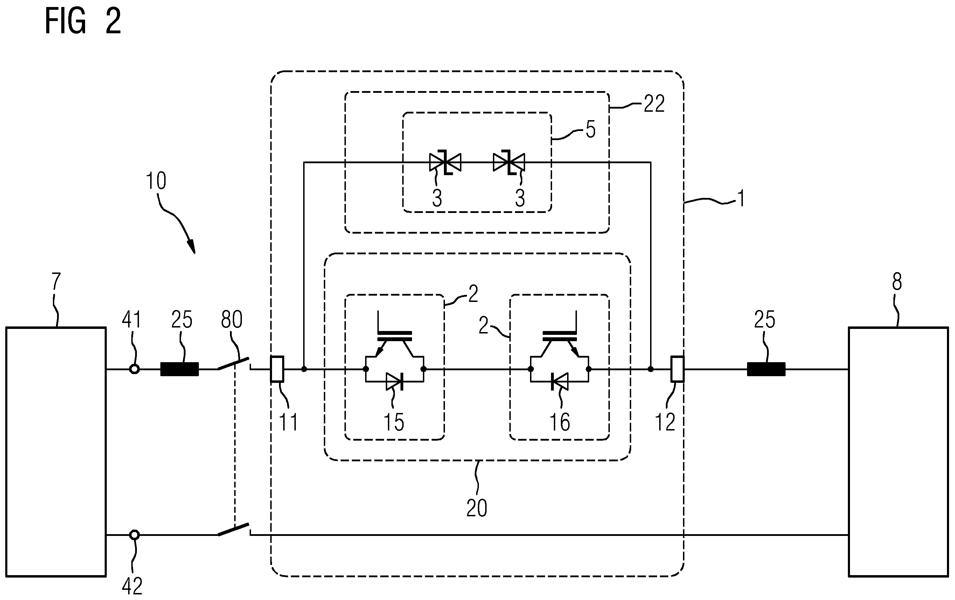

Die Figur 2 zeigt ein Gleichspannungssystem 10 mit einer Last 8, die von einem DC-Netz 7 gespeist wird. Zwischen dem ersten Potential 41 und dem zweiten Potential 42 liegt die Gleichspannung des DC-Netzes 7 an. Zwischen DC-Netz 7 und Last 8 ist ein elektronischer Schalter 1 angeordnet. Neben diesem elektronischen Schalter 1 befindet sich noch ein Schütz oder Trenner 80, mit dem die Last 8 vom DC-Netz 7 galvanisch getrennt werden kann. Für die Funktion des elektronischen Schalters 1 ist das Schütz oder der Trenner 80 aber nicht zwingend erforderlich.

Die in den Zuleitungen vorhandenen Induktivitäten sind durch das Element 25 dargestellt. Dabei kann es sich um parasitäre Induktivitäten von Leitungen oder auch um induktive Bauelemente, wie Drosseln, Spulen oder Transformatoren handeln. Der elektronische Schalter 1 weist zwischen seinem ersten Anschluss 11 und seinem zweiten Anschluss 12 eine Reihenschaltung von zwei abschaltbaren Halbleiterschaltern 2 auf. Diese sind antiseriell zueinander angeordnet. Das bedeutet, dass das Schaltelement der beiden abschaltbaren Halbleiterschalter 2 jeweils einen Strom mit unterschiedlicher Richtung führen und damit schalten kann. Zur Erhöhung der Sperrfähigkeit, d.h. der zu schaltenden Spannung kann die Anzahl der abschaltbaren Halbleiterschalter 2 in der Reihenschaltung 5 weiter erhöht werden.

Antiparallel zu dem jeweiligen Schaltelement der abschaltbaren Halbleiterschalter 2 ist eine Diode 15, 16 angeordnet. Durch die Diode 15, 16 kann also ein Strom in die jeweilige andere Richtung fließen als der Strom durch das entsprechende Schaltelement des abschaltbaren Halbleiterschalters 2. Die antiserielle Anordnung der beiden abschaltbaren Halbleiterschalter 2 führt dazu, dass der Strom zwischen erstem Anschluss 11 und zweitem Anschluss 12 durch eine Diode des einen abschaltbaren Halbleiterschalters 2 und durch ein Schaltelement des anderen abschaltbaren Halbleiterschalters 2 fließt.

Die Reihenschaltung der abschaltbaren Halbleiterschalter 2 ist mit dem ersten Potential 41 des DC-Netzes 7 verbunden. Der elektronische Schalter 1 weist darüber hinaus zwei Suppressor-Dioden 3 auf, die eine Reihenschaltung 5 bilden. Die Reihenschaltung 5 ist parallel zu den beiden Halbleiterschaltern 2 geschaltet, also ebenso wie diese zwischen den ersten und zweiten Anschluss 11, 12. Bei dem vorliegenden Gleichspannungssystem 10 handelt es sich um ein Netzwerk mit einer Betriebsspannung von 400 V. In diesem Beispiel sollen als Halbleiterschalter 2 solche mit einer Spannungsfestigkeit von 650 V verwendet werden.

Die konkrete Anzahl der Suppressor-Dioden 3 ergibt sich in diesem Beispiel wie in den folgende Beispielen aus einer Abwägung der vorliegenden Parameter des Gleichspannungssystems 10. Sind diese bekannt, kann die Anzahl und Art der gewählten Suppressor-Dioden 3 daran angepasst werden, wie es in diesem Beispiel passiert. Sind die Parameter, beispielsweise die an den elektronischen Schalter 1 angeschlossenen Induktivitäten, unbekannt, kann eine Konfiguration des elektronischen Schalters 1 gewählt werden, die im Rahmen von minimalen und maximalen Parametern, also beispielsweise einer minimalen und maximalen Leitungsinduktivität in jedem Fall funktioniert. In dem ersten Ausführungsbeispiel wird davon ausgegangen, dass eine sehr hohe Leitungsinduktivität oder möglicherweise auch Lastinduktivität von 200 µH lastseitig an den elektronischen Schalter angeschlossen ist. Diese sorgt dafür, dass der Stromanstieg im Fehlerfall verhältnismäßig langsam vor sich geht. Die Zeitspanne, die nötig ist, um einen Fehler zu erkennen, spielt in diesem Fall nur eine untergeordnete Rolle und der Fehler kann schon bei einer verhältnismäßig geringen Stromstärke abgeschaltet werden. Die Spannungsspitze zu Beginn des Abschaltvorgangs, wie sie aus Figur 1 - bei anderen Parametern - erkennbar ist, fällt dadurch gering aus.

Daher können in diesem Beispiel zwei Suppressor-Dioden 3 der Art 30KPA216CA mit einer Durchbruchsspannung von ca. 265 V gewählt werden. Auch andere mit etwas höherer Durchbruchsspannung können gewählt werden, solange die Spannungsfestigkeit der Halbleiterschalter 2 nicht überschritten wird. Auch können in anderen Ausführungsvarianten beispielsweise sechs Suppressor-Dioden 3 mit einer Durchbruchsspannung von 95 V gewählt werden. Die Anzahl kann dabei unter Abwägung von beispielsweise der Energie bestimmt werden, die die Suppressor-Dioden 3 bei der Abschaltung aufnehmen müssen. Beträgt der Strom bei der Abschaltung in diesem Beispiel 200 A, dann ist die Peak-Leistung der Suppressor-Dioden 3 200 A * 265 V, beträgt also etwas mehr als 50 kW. Diese Peak-Leistung kann von den Suppressor-Dioden 3 aufgefangen werden, solange die Breite des Strompeaks, die in etwa der halben Dauer der Abschaltung entspricht, nicht größer als ca. 300 µs ist. Werden mehr Suppressor-Dioden 3 als nur zwei verwendet, sinkt die in jeder der Suppressor-Dioden 3 umgesetzt Leistung entsprechend der geringeren Spannung und für die Dauer der Abschaltung steht - zumindest in Bezug auf die Suppressor-Dioden 3 - mehr Zeit zur Verfügung.

Fließt nun ein Strom im ersten Potential 41 von dem DC-Netz 7 zur Last 8 durch den elektronischen Schalter 1, dann ist die Diode 15 leitend und die Diode 16 gesperrt. Der Strom fließt durch das Schaltelement des abschaltbaren Halbleiterschalters 2, der zu der Diode 16 parallel angeordnet ist. Schaltet nun der elektronische Schalter 1 ab, indem die abschaltbaren Halbleiterschalter 2 gesperrt werden, dann wird der Strom durch die Induktivität des Elementes 25, also beispielsweise die Leitungsinduktivitäten, weiter getrieben. Der weiter getriebene Strom führt nun zu einem raschen Spannungsaufbau über dem elektronischen Schalter 1, also zwischen dem ersten und zweiten Anschluss 11, 12. Ist die Summe der Durchbruchsspannungen der Suppressor-Dioden 3 erreicht, beginnen diese, Strom zu leiten und begrenzen damit die über die Reihenschaltung 5 abfallende Spannung auf die Summe der Durchbruchsspannungen. Die über die beiden abschaltbaren Halbleiterschalter 2 abfallende Spannung entspricht weitestgehend dieser Spannung. Dadurch sind die abschaltbaren Halbleiterschalter 2 vor einem weiteren Anstieg der Spannung und einer möglichen Schädigung geschützt.

In Messungen wie derjenigen der Figur 1 zeigt sich, dass die Spannung über die Suppressor-Dioden 3 initial, also direkt nach der Abschaltung, auf einen Wert steigt, der höher ist als die summierte Durchbruchsspannung der Suppressor-Dioden 3 ist. Möglicherweise wird hier die summierte maximale Klemmspannung (Maximum Clamping Voltage) oder sogar mehr erreicht. Nach dem Abschalten fällt die Spannung im Rahmen von etwa 1 µs auf den Wert der summierten Durchbruchsspannung ab. Dabei hängt die erreichte initiale Überspannung vom abgeschalteten Strom ab. IM ersten Ausführungsbeispiel wurde von einer hohen Induktivität und dadurch einem verhältnismäßig geringem Fehlerstrom ausgegangen. Die initiale Überspannung stellt dadurch kein erhebliches Problem dar und erfordert keine Gegenmaßnahmen.

Ist der elektronische Schalter 1 jedoch an eine nur geringe Leitungsinduktivität angeschlossen, steigt ein Fehlerstrom sehr schnell an. Dabei können Stromanstiegsgeschwindigkeiten von 200 A / µs erreicht werden. Die in diesem Fall erhebliche Totzeit, die verstreicht, bevor der elektronische Schalter 1 einen Fehlerstrom erkennt und abschaltet, führt dazu, dass der Strom höhere Wert von beispielsweise 470 A annimmt, bevor die Abschaltung stattfindet.

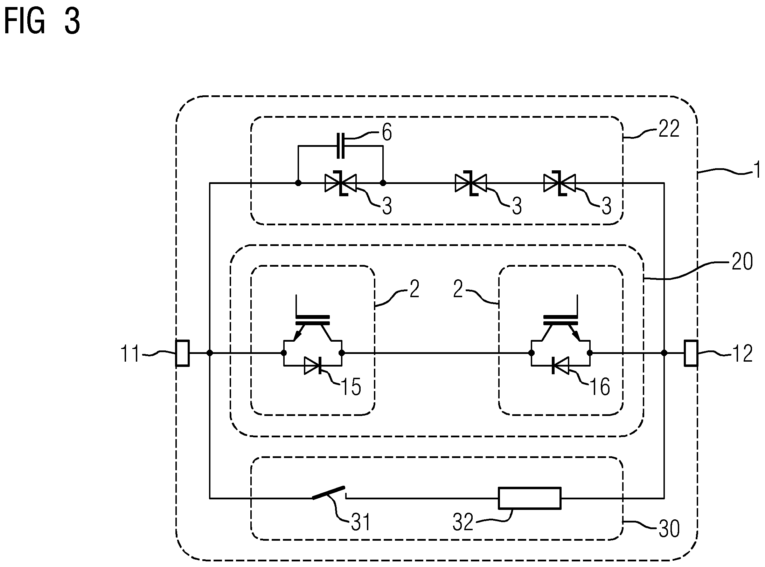

In diesem Fall die kann die initiale Überspannung problematisch werden. Ein solcher Fall ist in Figur 1 dargestellt. Figur 3 zeigt einen elektronischen Schalter 1 gemäß einem zweiten Beispiel. Im zweiten Beispiel wird davon ausgegangen, dass die Betriebsspannung eines zweiten, nicht gezeigten Gleichspannungssystems 800 V beträgt. Statt der im ersten Beispiel verwendeten Suppressor-Dioden 3 werden hier solche des Typs 30KPA280CA verwendet, deren Durchbruchsspannung 334 V beträgt. In diesem Fall sind also drei in Reihe geschaltete Suppressor-Dioden 3 notwendig, da erst mit drei Suppressor-Dioden 3 die summierte Durchbruchsspannung höher ist als die Betriebsspannung von 800 V. Die verwendeten Halbleiterschalter 2 sollen in dem zweiten Beispiel eine Spannungsfestigkeit von 1200 V haben. Zur Vermeidung von Wiederholungen wird auf die Beschreibung zu Figur 2 sowie auf die dort eingeführten Bezugszeichen verwiesen.

Ein realer elektronischer Schalter 1, der gemäß der Erfindung, insbesondere gemäß der Ausführungsform der Figuren 3 aufgebaut ist, umfasst typischerweise auch eine Vorladeschaltung 30, wie sie in Figur 3 dargestellt ist. Diese umfasst einen bidirektionalen Halbleiterschalter 31 in Serie mit einem Strombegrenzungswiderstand 32. Diese Vorladeschaltung 30 dient dazu, lastseitig vorliegende Kapazitäten vor einem Einschalten der Halbleiterschalter 2 aufzuladen, um einen extrem hohen Einschaltstrom zu vermeiden. Ist in einer Ausführungsform, die nicht der Erfindung zugehörig ist, der Kondensator 6 so geschaltet, dass er alle vorhandenen Suppressor-Dioden 3 überbrückt, dann wird die Vorladeschaltung auch vorteilhaft mitverwendet, um den Kondensator 6 vor einem Einschalten der Halbleiterschalter 2 zu entladen. Ist der Kondensator dagegen wie in Figur 3 gezeigt so verschaltet, dass eine oder mehrere Suppressor-Dioden 3 in Reihe dazu verbleiben, dann ist zumindest für den Kondensator 6 keine Entladung notwendig bei einem Einschaltvorgang.

Die Summe der Durchbruchsspannungen der Suppressor-Dioden 3 beträgt in diesem Beispiel 3 x 344 V = 1032 **V.** Ergibt sich nach einem Abschaltvorgang des elektronischen Schalters 1 diese Spannung über die Suppressor-Dioden 3 und somit auch über die beiden abschaltbaren Halbleiterschalter 2 und werden weiterhin abschaltbare Halbleiterschalter 2 mit einer Spannungsfestigkeit von 1200 V verwendet, dann stellt die somit erreichte maximale Überspannung kein Problem dar.

In der Praxis ergibt sich aber die bereits beschriebene initiale deutliche Überschreitung dieses Werts von 1032 V. Messungen ergeben einen initialen Spannungswert von zwischen 1600 V und 1700 V, also sogar etwas mehr als die dreifache maximale Klemmspannung, die ca. 1400 V beträgt. Eine solche Überspannung würde nachteiligerweise Halbleiterschalter 2 mit einer höheren Spannungsfestigkeit, also mindestens einer Spannungsfestigkeit von 1600 V, erforderlich machen. Diese sind deutlich teurer als solche mit einer Spannungsfestigkeit von 1200 V und daher unattraktiv.

Um dem Problem zu begegnen, ist im zweiten Ausführungsbeispiel ein Kondensator 6 vorhanden, der parallel zu einer ersten der drei Suppressor-Dioden 3 geschaltet ist. Die Kapazität des Kondensators 6 beträgt in diesem Ausführungsbeispiel 1 µF, also mehr als eine Größenordnung weniger als typische Kondensatoren in bekannten Entlastungsnetzwerken wie den in der Einleitung erwähnten.

Der Kondensator 6 bewirkt, dass im ersten Moment der Kommutierung des Laststroms von den abschaltbaren Halbleiterschaltern 2 auf die Suppressor-Dioden 3 eine der Suppressor-Dioden 3 durch den Kondensator 6 überbrückt wird. Der Kondensator 6 ist in dem Moment der Abschaltung ungeladen, da im eingeschalteten Zustand fast keine Spannung am elektronischen Schalter 1 abfällt. Durch das Überbrücken der ersten Suppressor-Diode 3 reduziert sich die Durchbruchsspannung der Reihenschaltung aus Suppressor-Dioden 3 um die Durchbruchsspannung einer solchen Suppressor-Diode 3, in diesem Fall also um ca. 344 V auf nunmehr 688 V. Die initial auftretende Überspannung wird dadurch ebenfalls abgesenkt auf einen Betrag von ca. 1100 V auf, wodurch Halbleiterschalter 2 mit einer Spannungsfestigkeit von 1200 V verwendet werden können.

In dem zweiten Ausführungsbeispiel wird davon ausgegangen, dass der elektronische Schalter 1 auf einen Betriebsstrom von 44 A ausgelegt ist und bei einem fünffachen Überstrom, also bei 220 A, eine Abschaltung vornimmt. Die damit auftretende Verlustleistung in einer der Suppressor-Dioden 3 beträgt also 220 A * 344 V, also ca. 75 kW. Eine solche Peak-Verlustleistung ist laut dem Datenblatt des hier verwendeten Suppressor-Dioden 3 für eine Strompeak-Weite von ca. 180 µs möglich. Versuche mit einer für typische Leitungsinduktivitäten deutlich überdimensionierten Induktivität von 230 µH haben gezeigt, dass die sich ergebenden Strompeaks eine Breite im Bereich weniger µs aufweisen, also noch erheblicher Spielraum verbleibt. Die beschriebene Betriebsform stellt daher für die verwendeten Suppressor-Dioden 3 auch dann kein Problem dar, wenn beispielsweise für die Betrachtung der Peak-Leistung die maximale Klemmspannung verwendet wird. Da in dem zweiten Ausführungsbeispiel von einer geringen Leitungsinduktivität ausgegangen wurde, findet der gesamte Abschaltvorgang innerhalb weniger µs statt, so dass die maximalen Leistungswerte unproblematisch sind.

Wie beim ersten Ausführungsbeispiel ist die Anzahl der Suppressor-Dioden 3 und deren genaue Auswahl eine Frage der Abwägung verschiedener Faktoren. Auch im zweiten Ausführungsbeispiel können mehr als drei Suppressor-Dioden 3 verwendet werden, die eine geringere Durchbruchsspannung aufweisen. Eine höhere Gegenspannung und damit eine schnellere Abschaltung ließe sich beispielsweise mit sechs Suppressor-Dioden 3 mit einer Durchbruchsspannung von 190 V erreichen, also einer summierten Durchbruchsspannung von 1140 V. Dabei ist aber auch mit einer höheren initialen Überspannung zu rechnen. Dieser kann begegnet werden, indem der Kondensator 6 parallel zu zwei oder sogar drei der Suppressor-Dioden 3 geschaltet wird. Es wird also eine feinere Einstellung der Spannungen auf Kosten einer erhöhten Zahl von Suppressor-Dioden 3 erreicht.

### Bezugszeichen

- 1: elektronischer Schalter
- 2: Halbleiterschalter
- 3: Suppressor-Dioden
- 5: Reihenschaltung
- 6: Kondensator
- 7: DC-Netz
- 8: Last
- 10: Gleichspannungssystem
- 11: erster Anschluss
- 12: zweiter Anschluss
- 15, 16: Dioden
- 20: abschaltbares bidirektionales Halbleiter-Schaltelement
- 22: Spannungsbegrenzungs-Schaltung
- 25: Induktivitäten
- 30: Vorladeschaltung
- 31: bidirektionaler Halbleiterschalter
- 32: Strombegrenzungswiderstand
- 41: erstes Potential
- 42: zweites Potential
- 80: Trenner
- 101: Stromverlauf
- 102: Spannungsverlauf
- 103, 104: Zeitpunkte

## Patentansprüche

1. Elektronischer Schalter (1) mit
- einem ersten und einem zweiten Anschluss (11, 12), zwischen denen eine elektrisch leitende Verbindung herstellbar oder unterbrechbar ist,
- wenigstens einem bidirektionalen abschaltbaren Halbleiter-Schaltelement (20), das zwei anti-seriell oder anti-parallel geschaltete Halbleiterschalter (2) umfasst und zwischen dem ersten und zweiten Anschluss (11, 12) angeordnet ist und mittels dem die Verbindung zwischen dem ersten und zweiten Anschluss herstellbar oder unterbrechbar ist, und
- einer Spannungsbegrenzungs-Schaltung (22), die parallel zu dem Halbleiter-Schaltelement (20) geschaltet ist, wobei die Spannungsbegrenzungs-Schaltung (22) mehrere bidirektionale Suppressor-Dioden (3) in einer Serienschaltung (5) umfasst und wobei ein Kondensator (6) parallel zu einer oder mehreren, aber weniger als allen der Suppressor-Dioden (3) angeordnet ist.

2. Elektronischer Schalter (1) nach Anspruch 1, bei dem der Kondensator (6) parallel zu genau einer der Suppressor-Dioden (3) angeordnet ist.

3. Elektronischer Schalter (1) nach einem der vorangehenden Ansprüche, bei dem die Summe der Durchbruchsspannungen aller Suppressor-Dioden (3) kleiner als die Spannungsfestigkeit des Halbleiter-Schaltelements (20) ist.

4. Elektronischer Schalter (1) nach Anspruch 3, bei dem die Summe der Durchbruchsspannungen aller Suppressor-Dioden (3) größer als 60 %, insbesondere größer als 80 % der Spannungsfestigkeit des Halbleiter-Schaltelements (20) ist.

5. Elektronischer Schalter (1) nach einem der vorangehenden Ansprüche, bei dem der Kondensator (6) eine Kapazität von weniger als 20 µF, insbesondere weniger als 5 µF aufweist.

6. Elektronischer Schalter (1) nach einem der vorangehenden Ansprüche, bei dem das Halbleiter-Schaltelement (20) eine Spannungsfestigkeit von wenigstens 1200 V aufweist.

7. Elektronischer Schalter (1) nach einem der vorangehenden Ansprüche mit einer Vorladeschaltung (30) umfassend eine Serienschaltung mit einer Schalteinrichtung (31) und einem Strombegrenzungswiderstand (32), wobei die Vorladeschaltung (30) parallel zu dem Halbleiter-Schaltelement (20) geschaltet ist.

8. Elektrisches Netzwerk, insbesondere DC-Netzwerk (7) mit wenigstens einem elektronischen Schalter (1) nach einem der vorangehenden Ansprüche, bei dem die summierte Durchbruchsspannung der Suppressor-Dioden (3) größer ist als die Betriebsspannung des elektrischen Netzwerks.

9. Elektrisches Netzwerk nach Anspruch 8, bei dem die Betriebsspannung wenigstens 400 V, insbesondere wenigstens 800 V beträgt.

## Claims

1. Electronic switch (1) having
- a first and a second terminal (11, 12) between which an electrically conductive connection is able to be established or interrupted,
- at least one bidirectional turn-off semiconductor switching element (20) which comprises two semiconductor switches (2) connected in antiseries or in antiparallel and which is arranged between the first and second terminals (11, 12) and by means of which the connection between the first and second terminals is able to be established or interrupted, and
- a voltage-limiting circuit (22) which is connected in parallel with the semiconductor switching element (20), wherein the voltage-limiting circuit (22) comprises a plurality of bidirectional suppressor diodes (3) in a series connection (5) and wherein a capacitor (6) is arranged in parallel with one or more, but less than all, of the suppressor diodes (3).

2. Electronic switch (1) according to Claim 1, in which the capacitor (6) is arranged in parallel with exactly one of the suppressor diodes (3).

3. Electronic switch (1) according to either of the preceding claims, in which the sum of the breakdown voltages of all the suppressor diodes (3) is less than the dielectric strength of the semiconductor switching element (20).

4. Electronic switch (1) according to Claim 3, in which the sum of the breakdown voltages of all the suppressor diodes (3) is greater than 60 %, in particular greater than 80 %, of the dielectric strength of the semiconductor switching element (20).

5. Electronic switch (1) according to one of the preceding claims, in which the capacitor (6) has a capacitance of less than 20 µF, in particular less than 5 µF.

6. Electronic switch (1) according to one of the preceding claims, in which the semiconductor switching element (20) has a dielectric strength of at least 1200 V.

7. Electronic switch (1) according to one of the preceding claims, having a precharging circuit (30) comprising a series connection comprising a switching device (31) and a current-limiting resistor (32), wherein the precharging circuit (30) is connected in parallel with the semiconductor switching element (20) .

8. Electrical network, in particular DC network (7) having at least one electronic switch (1) according to one of the preceding claims, in which the summed breakdown voltage of the suppressor diodes (3) is greater than the operating voltage of the electrical network.

9. Electrical network according to Claim 8, in which the operating voltage is at least 400 V, in particular at least 800 V.

## Revendications

1. Interrupteur (1) électronique comprenant
- une première et une deuxième bornes (11, 12), entre lesquelles une liaison conductrice de l'électricité peut être produite ou peut être interrompue,
- au moins un élément (20) de coupure bidirectionnelle à semiconducteur pouvant être bloqué, qui comprend deux interrupteurs (2) à semiconducteur montés en anti-série ou en anti-parallèle et qui est disposé entre la première et la deuxième bornes (11, 12) et au moyen duquel la liaison entre la première et la deuxième bornes peut être produite ou peut être interrompue, et
- un circuit (22) de limitation de la tension, qui est monté en parallèle avec l'élément (20) de coupure à semiconducteur, dans lequel le circuit (22) de limitation de la tension comprend plusieurs diodes (3) de suppression bidirectionnelles en un circuit (5) série et dans lequel un condensateur (6) est monté en parallèle avec l'une ou plusieurs, mais moins que toutes les diodes (3) de suppression.

2. Interrupteur (1) électronique suivant la revendication **1,** dans lequel le condensateur (6) est monté en parallèle avec exactement l'une des diodes (3) de suppression.

3. Interrupteur (1) électronique suivant l'une des revendications précédentes, dans lequel la somme des tensions de claquage de toutes les diodes (3) de suppression est plus petite que la rigidité diélectrique de l'élément (20) de coupure à semiconducteur.

4. Interrupteur (1) électronique suivant la revendication 3, dans lequel la somme des tensions de claquage de toutes les diodes (3) de suppression est plus grande que 60 %, en particulier plus grande que 80 % de la rigidité diélectrique de l'élément (20) de coupure à semiconducteur.

5. Interrupteur (1) électronique suivant l'une des revendications précédentes, dans lequel le condensateur (6) a une capacité de moins de 20 µF, en particulier de moins de 5 µF.

6. Interrupteur (1) électronique suivant l'une des revendications précédentes, dans lequel l'élément (20) de coupure à semiconducteur a une rigidité diélectrique de moins de 1 200 V.

7. Interrupteur (1) électronique suivant l'une des revendications précédentes comprenant un circuit (30) de précharge comprenant un circuit série ayant un dispositif (31) de coupure et une résistance (32) de limitation du courant, le circuit (30) de précharge étant monté en parallèle avec l'élément (20) de coupure à semiconducteur.

8. Réseau électrique, en particulier réseau (7) à courant continu comprenant au moins un interrupteur (1) électronique suivant l'une des revendications précédentes, dans lequel la tension de claquage sommée des diodes (3) de suppression est plus grande que la tension de fonctionnement du réseau électrique.

9. Réseau électrique suivant la revendication 8, dans lequel la tension de fonctionnement s'élève à au moins 400 V, en particulier à au moins 800 V.
